# EUROPEAN PATENT APPLICATION

(11) **EP 4 641 597 A1**
(43) Date of publication of application: **29.10.2025**
(21) Application number: 24305621.5
(22) Date of filing: 23.04.2024
(51) Int. Cl.: H01G 4/33, H01G 4/008, H01G 4/012, H01G 4/08, H01G 4/12, H01G 4/005

(54) **METHOD OF FORMING A CAPACITOR OR AN IONIC CAPACITOR, WITH AN ELECTRODE COMPRISING A NOBLE METAL**

(71) Applicant: Murata Manufacturing Co., Ltd., Nagaokakyo-shi, Kyoto 617-8555 (JP); Commissariat à l'Energie Atomique et aux Energies Alternatives, 75015 Paris (FR)
(72) Inventor: SALLAZ, Valentin, 38000 GRENOBLE (FR); VOIRON, Frédéric, 38530 BARRAUX (FR); BUFFLE, Larry, 38000 GRENOBLE (FR); BEDJAOUI, Messaoud, 38054 GRENOBLE CEDEX 09 (FR); OUKASSI, Sami, 38054 GRENOBLE CEDEX 09 (FR); POULET, Sylvain, 38054 GRENOBLE CEDEX 09 (FR)
(74) Representative: Cabinet Beau de Loménie

(57) **Abstract**

A method of forming an integrated component, for example a capacitor or an ionic capacitor, comprising:
forming a stacked structure comprising, on a substrate (400, 405, AAO), a bottom electrode, an intermediate layer (420) comprising a layer of dielectric material or a layer of ionic conductor, and a top electrode,
wherein forming the top and/or the bottom electrode comprises forming a liner layer (430) of material, and
forming a metallic layer (435) on the liner layer, the metallic layer comprising a noble metal,
wherein the metallic layer is thicker than the liner layer.

## Description

### Field of the Invention

The present invention relates to the field of integration and, more particularly, to electronic products comprising capacitors or ionic capacitors, their methods of manufacture.

### Technical Background

Various technologies have been developed for integrating passive components, such as energy storage components, capacitive devices, etc. in/on substrates such as silicon wafers.

There is a general desire to construct integrated energy storage components that provide a high energy storage density. Various approaches have been tried in this regard. In the case of capacitive devices, conventional approaches for increasing capacitance include reducing the thickness of the dielectric layer (subject to the constraint of avoiding dielectric breakdown when the operating voltage is applied) and selecting a material having high dielectric constant as the material of the dielectric layer.

More recently, proposals have been made to form the conductive layers and dielectric layer of an integrated energy storage component conformally over a contoured surface (i.e. forming the conductive layers and dielectric layer so that their shape conforms to the shape of the underlying surface) rather than employing planar layers. Energy storage components of this type may be referred to as "three-dimensional" components (to differentiate them from planar devices). As an example, the PICS technology proposed by Murata Integrated Passive Solutions employs three-dimensional capacitive components and allows high density capacitive components to be integrated into a silicon substrate.

Recently, three-dimensional capacitive components have been fabricated by embedding a Metal-Insulator-Metal (MIM) structure in a porous anodized material, for example in porous anodized alumina (PAA). This technology provides highly-integrated capacitance which can be used for many applications. This technology implements a capacitive stack (for example a MIM stack) in a porous structure which is formed above a substrate such as a silicon wafer. The porous structure may result from the anodization of a thin layer of aluminum deposited above the substrate (e.g. deposited on the substrate or deposited on one or more layers which are themselves formed on the substrate). The anodization process converts the Al into alumina, which is porous (PAA). A mask may optionally be formed over the aluminium layer before anodization takes place, so that anodization process forms islands of porous material.. These components, using a dielectric in the MIM stack, are referred to as capacitors in the present descriptions.

There also exist devices making use of ionic conductor having electronic insulating properties (called ionic conductors in the present application) between electrodes, referred to as ionic capacitors, the ionic conductors are electrolytes such as LiPON. These ionic capacitors may also be accommodated in a porous anodized alumina structure.

Forming (non-ionic) capacitors or ionic capacitors within the pores of anodic porous oxide, or inside other types of 3D structures, can be particularly difficult to implement. In particular, the layers of the capacitors or ionic capacitors have to be deposited in a conformal manner, have to be particularly thin so as to allow the conformal deposition to occur all over the pores or reliefs, and have to maintain a low ESR (for the electrode layers).

In many devices, titanium nitride TiN is used as electrode material. This material is often deposited using Cl-based precursors such as TiCl4 as it leads to electrode layers with an acceptable resistivity (of the order of 100µOhm.cm).

The use of other precursors may be problematic, in particular I-based precursors or Br-based precursors.

It has been observed that the Cl-based elements can be trapped in the capacitors or ionic capacitors subsequent to depositing TiN. This is particularly true for top electrode layers (i.e. the electrode formed directly on a dielectric layer or on an ionic conductor layer). The material of the dielectric or ionic conductor layer can be chemically affected by the presence of Cl-based elements. This can lead to an increase of the leakage current or corrosion in the obtained device.

There exists ALD methods to form TiN electrodes that do not use CI-based precursors. For example, Tetrakis(dimethylamido)titanium (TDMAT), Tetrakis(diethylamino)titanium(IV) (TDEAT), Titanium tetrabromide (TiBr4) can be used as precursors. However, these cannot be used to form capacitor electrodes as the resulting TiN can have a resistivity above 1 kOhm.cm.

There exists a need for an electrode material that avoids the presence of Cl-based elements and that maintains an acceptable ESR.

The invention has been made in the light of the above problems.

### Summary of the Invention

The invention provides a device including an integrated component, comprising:
a substrate,
on the substrate, a stacked structure comprising a bottom electrode, an intermediate layer comprising a layer of dielectric material or a layer of ionic conductor (or a combination of both), and a top electrode (the top electrode layer is on the intermediate layer),
wherein the top and/or the bottom electrode comprises:
   a liner layer of material (on the intermediate layer for a top electrode layer, on the substrate for a bottom electrode layer),
   a metallic layer on the liner layer, the metallic layer comprising a noble metal (one or more noble metals), or an intermetallic material(one or more intermetallic materials), or a refractory metal (one or more refractory metals),
   wherein the metallic layer is thicker than the liner layer, for example at least five times thicker.

The above component may be a capacitor (for example if the intermediate layer comprises a layer of dielectric material), or an ionic capacitor (for example if the intermediate layer comprises a layer of ionic conductor), or even a via.

Thus, the invention proposes mitigating the high resistivity of a layer that can be deposited using any appropriate technique and in particular techniques that are not Cl-based (or I-based, or Br-based, etc.) for the precursor, with a layer of noble metal or intermetallic, or refractory. This allows benefiting from the low resistivity of the selected material.

Also, it has been observed that noble metals (or intermetallic, or refractory) can be deposited without using Cl-based precursors (or others), and that their resistivity is usually below 50µOhm.cm. Their deposition is however particularly difficult to implement. For example for noble metals, in particular for thin layers up to 15 nanometers, as they usually nucleate into discontinuous islands during the ALD process (which also leads to a non-uniform thickness if the deposition process if performed for a given duration). It has however been observed that liners of suitable materials can minimize the islands formation (compared to a noble metal deposited on an insulating layer, for instance), which leads to a more uniform thickness and a continuous layer. In particular, the word liner designates a continuous layer (i.e. a single layer with no interruption).

Besides, as the formation of the continuous metallic layer occurs at reduced thickness this allows implementing thinner conductive electrodes. This is of particular interest when this is used to implement the bottom electrode. Indeed, it is known from the earlier art (cylindrical capacitor formula) that the thinner is the bottom electrode for a given pore diameter (when a capacitor is implemented within a porous structure), the larger is the effective capacitive area. Implementing such a composite conductive layer as the bottom electrode brings an advantage in term of capacitive density, compared to a monolayer because of the retarded nucleation for 3D applications, typically when a capacitor is implemented within a porous structure.

It should be noted that noble metals are also blocking when an ionic conductor is used. Typically and for example, for ionic applications the retarded nucleation of noble metals is more pronounced due to potential chemical surface inhibition as consequential use of ionic elements (Li, Na...). Thus, it's obvious that ALD-conformality of ultrathin top electrode layer on ionic layer is altered as density porous structures enhance.

It should be noted that the top electrode layer is called "top" as it is the last electrode layer to be formed as it is formed on a pre-existing structure, and the bottom electrode layer is called "bottom" as it is the first electrode layer to be formed on the substrate.

According to a particular embodiment, the metallic layer has a thickness comprised between 5 and 20 nanometres and/or wherein the liner layer is thinner than 1 nanometre.

These thicknesses are suitable for devices accommodated in the pores of anodic porous oxide, which typically have a diameter of about 100 nanometres.

According to a particular embodiment, the liner layer is more resistive than the metallic layer, for example the liner layer has a resistivity of less than 50µOhm.cm and the metallic layer has a resistivity of more than 50µOhm.cm.

According to a particular embodiment, the material of the liner layer is an electron conducting material (i.e. they can be conductors or conduct electrons through other mechanisms including tunnelling), for example a metal or a compound-transition-metal or a low bandgap dielectric or a trap rich dielectric allowing direct or indirect electrons tunnelling, for example selected from the list comprising: TiN, TiOx, AIOx, AIN, TaN, TaOx, MoN, WN.

According to a particular embodiment, the metallic layer comprises a noble metal selected from the list comprising: Pt, Ru, Au, or the metallic layer comprises an intermetallic material selected from the list comprising Ni-Al, Ti-Al, or the metallic layer comprises a refractory metal selected from the list comprising Cr, Mo.

According to a particular embodiment, the intermediate layer comprises at least one material selected from the list comprising: SiON, HfSiOₓ, SiₓO_{y}, SiₓN_{y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K.

For example, the intermediate layer has a thickness comprised between 5 and 30 nanometres.

Also, combinations of materials from this list may also be considered.

According to a particular embodiment, the top electrode comprises the liner layer and the metallic layer, and wherein the bottom capacitor layer comprising a material selected from the list comprising: TiN, Ru, Pt, Au, Cu, W, Mo, AIN, Si, Ti, Al, Co.

According to a particular embodiment, the stacked structure is a 3D structure wherein the bottom capacitor electrode is contoured, and wherein the intermediate layer, the liner layer and the metallic layer are conformal.

By contoured, what is meant is that the bottom electrode has a surface that extends in three dimensions. For example, it is shaped in the form of straight pores, trenches, holes, walls.

According to a particular embodiment, the substrate comprises an anodic porous oxide region (AAO) comprising a plurality of substantially straight pores that extend from a top surface of the anodic porous oxide region, and wherein the bottom capacitor electrode layer, the intermediate layer, and the top capacitor electrode layer are arranged conformally inside the pores of the anodic porous oxide region.

The invention also provides a method of forming an integrated component, comprising:
forming a stacked structure comprising, on a substrate, a bottom electrode, an intermediate layer comprising a layer of dielectric material or a layer of ionic conductor (or a combination of both; also, the intermediate layer is on the bottom electrode layer), and a top electrode (the top electrode layer is on the intermediate layer),
wherein forming the top and/or the bottom electrode comprises forming a liner layer of material (on the intermediate layer for a top electrode layer, on the substrate for a bottom electrode layer), and
forming a metallic layer on the liner layer, the metallic layer comprising a noble metal, or an intermetallic material, or a refractory metal,
wherein the metallic layer is thicker than the liner layer, for example at least five times thicker.

The above component may be a capacitor (for example if the intermediate layer comprises a layer of dielectric material), or an ionic capacitor (for example if the intermediate layer comprises a layer of ionic conductor), or even a via.

Thus, the invention proposes mitigating the high resistivity of a layer that can be

According to a particular embodiment, the liner layer is formed by a deposition under a Frank-Van der Merwe growth mode (also referred to as a 2D or planar growth mode).

This allows the liner layer to be as continuous as possible, even for sub-nanometre thicknesses.

The liner in this embodiment forces the next deposited layer (i.e. the noble metal or intermetallic or refractory layer) to grow into a more 2D/planar mode (Frank-Van Der Merwe's mode), when it would have naturally growth in 3D/island mode (Volmer Weber's) or Mixed 3D/2D mode (Stranski Krastanov's) without.This arrangement is particularly beneficial when the resistivity of the metallic layer (if a metal is used, for example) is lower than the one of the liner layer.

According to a particular embodiment, the metallic layer has a thickness comprised between 5 and 20 nanometres and/or wherein the liner layer is thinner than 1 nanometre.

These thicknesses are suitable for devices accommodated in the pores of anodic porous oxide, which typically have a diameter of about 100 nanometres.

According to a particular embodiment, the liner layer is more resistive than the metallic layer, for example the liner layer has a resistivity of less than 50µOhm.cm and the metallic layer has a resistivity of more than 50µOhm.cm.

According to a particular embodiment, the material of the liner layer is an electron conducting material (i.e. they can be conductors or conduct electrons through other mechanisms including tunnelling), for example a metal or a compound-transition-metal or a low bandgap dielectric or a trap rich dielectric allowing direct or indirect electrons tunnelling, for example selected from the list comprising: TiN, TiOx, AlOx, AIN, TaN, TaOx, MoN, WN.

According to a particular embodiment, the liner layer is deposited by ALD using an organometallic precursor, for example comprising TDMAT or TDEAT or TMA or Al-TDMA.

These organometallic precursors are not CI-based (or others, for example Halidefree) and therefore cannot contaminate the underlying structure.

According to a particular embodiment, the metallic layer comprises a noble metal selected from the list comprising: Pt, Ru, Au, or the metallic layer comprises an intermetallic material selected from the list comprising Ni-Al, Ti-Al, or the metallic layer comprises a refractory metal selected from the list comprising Cr, Mo..

These materials have been observed to be particularly adapted for the manufacture of capacitors or ionic capacitors.

According to a particular embodiment, the intermediate layer comprises at least one material selected from the list comprising: SiON, HfSiOₓ, SiₓO_{y}, SiₓN_{y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K.

For example, the intermediate layer has a thickness comprised between 5 and 30 nanometres.

Also, combinations of materials from this list may also be considered.

According to a particular embodiment, the top electrode comprises the liner layer and the metallic layer, and the bottom electrode layer comprises the same liner layer and the same metallic layer, or a material selected from the list comprising: TiN, Ru, Pt, Au, Cu, W, Mo, AIN, Si, Ti, Al, Co

For example, the bottom electrode layer has a thickness below 30 nanometres, preferably comprised between 5 and 10 nanometres.

According to a particular embodiment, the liner layer and the metallic layer are formed by ALD.

In particular, the liner layer and the metallic layer are formed in a same ALD sequence, without any air break between the two depositions.

According to a particular embodiment, the stacked structure is a 3D structure wherein the bottom electrode is contoured, and wherein the intermediate layer, the liner layer and the metallic layer are conformal.

By contoured, what is meant is that the bottom electrode has a surface that extends in three dimensions. For example, it is shaped in the form of straight pores, trenches, holes, walls.

According to a particular embodiment, the substrate comprises an anodic porous oxide region comprising a plurality of substantially straight pores that extend from a top surface of the anodic porous oxide region, and wherein the bottom electrode layer, the intermediate layer, and the top electrode layer are arranged conformally inside the pores of the anodic porous oxide region.

### Brief Description of the Drawings

Further features and advantages of the present invention will become apparent from the following description of certain embodiments thereof, given by way of illustration only, not limitation, with reference to the accompanying drawings in which:
- Figure 1 is a schematic representation of a device according to an example,
- Figure 2 is a schematic representation of a device according to an example,
- Figure 3 is a schematic representation of a device according to an example, and
- Figure 4 is a schematic representation of a device according to an example, arranged on an anodic porous oxide region.

### Detailed Description of Example Embodiments

We will now describe capacitors and ionic capacitors, along with the methods and steps used to obtain these capacitors and ionic capacitors.

Other integrated components may also be envisaged, for example vias.

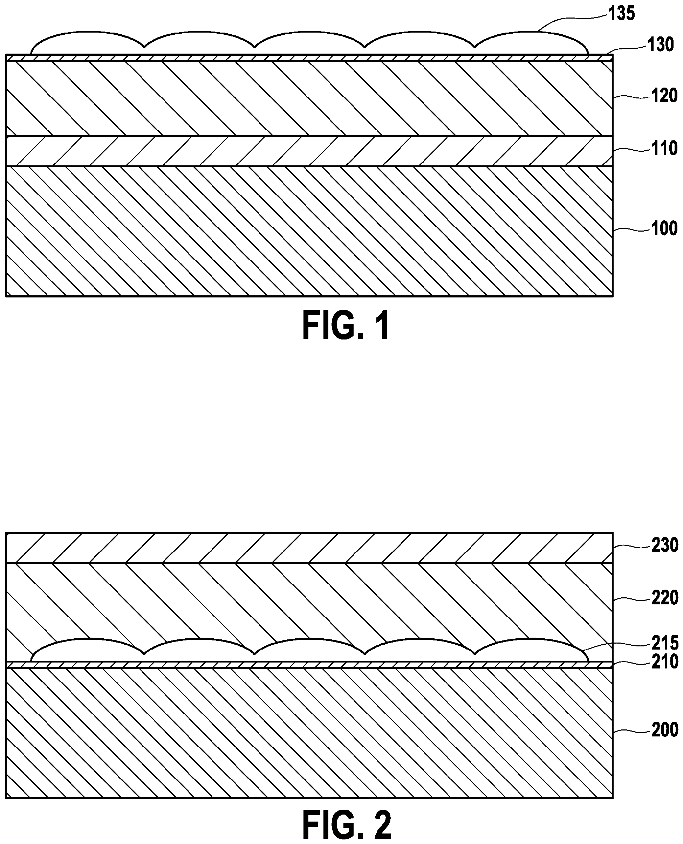

Figure 1 is an exemplary device comprising a substrate 100. This substrate can comprise a semiconductor region (typically silicon), or also glass or other materials.

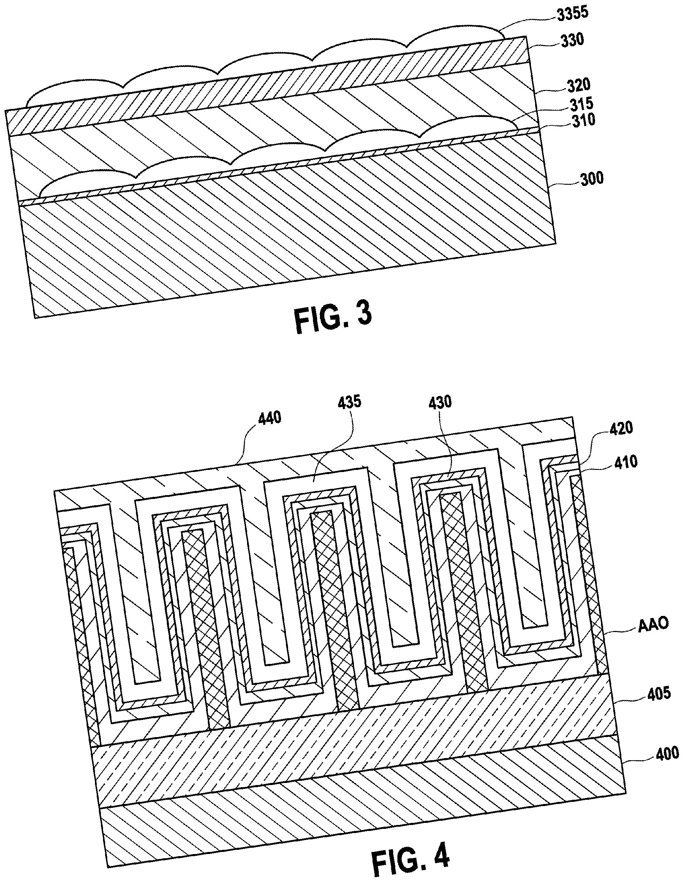

The substrate 100 of figure 1 is planar. The invention applies to both planar devices but is particularly advantageous for three-dimensional devices. Figure 4, described hereinafter shows such a three-dimensional device.

Above the substrate and on this substrate, a bottom electrode 110 has been formed. This bottom electrode is in the example of figure 1 a single layer (this is non limiting, other options described hereinafter present bottom electrodes including multiple layers), and can have a thickness below 30 nanometres and preferably close to 5 nm. It can also comprise a material selected from the list comprising: TiN, Ru, Pt, Au, Cu, W, Mo, AIN, Si, Ti, Al, Co. For example, if titanium nitride is used, it can be deposited using ALD techniques, for example using a CI-based precursor to obtain a layer having a low resistivity.

Subsequently, an intermediate layer 120 which is either a (non-ionic) dielectric or an ionic conductor layer is deposited. By way of example, the intermediate layer comprises a material selected from the list comprising: SiON, HfSiOₓ, SiₓO_{y}, SiₓN_{y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K. The intermediate layer may also comprise a combination of materials from this list.

Also, the intermediate layer may have a thickness comprised between 5 and 30 nanometres.

A liner layer 130 has been deposited by ALD on the intermediate layer. This liner layer has a thickness which is preferably below 1 nanometre. Also, the liner layer 130 can comprise a material selected from the list comprising: TiN, TiOx, AIOx, AIN, TaN, TaOx, MoN, WN. In particular, the liner layer 130 preferably conducts electrons, for example a metal or a compound-transition-metal or a low bandgap dielectric or a trap rich dielectric allowing direct or indirect electrons tunnelling. These materials can be deposited by ALD using organometallic precursors that do not include chlorine, so as to avoid contamination within the structure and in particular, TDMAT or TDEAT or TMA or AI-TDMA may be used.

The liner layer may have a high resistivity or allow electron conduction by direct or indirect tunnelling effect (for example, its resistivity may be lower than the one of the metallic layer comprising a noble metal) and is therefore preferably kept thin.

Also, the liner layer is chosen to have a low (ideally non-existent) bandgap, so as to accept electronic charges conduction.

On the liner layer, a metallic layer 135 has been deposited. The metallic layer comprises a noble metal, preferably Pt, or Ru, or Au in the illustrated embodiment. The invention is however not limited to noble metals and also applies to using an intermetallic material (for example Ni-Al, Ti-Al) or a refractory metal (for example Cr, Mo). Combinations of said materials may also be used.

While depositing noble metals directly on SiO2 or on LiPON (for example) has been observed to be particularly difficult as the material nucleates and forms separate islands (in particular for thicknesses below 15 nanometres), this behaviour is mitigated by the presence of the liner of conductive material. In fact, it has been observed that the presence of the liner layer has an impact such that the surface is in a thermodynamic condition that is more favourable to a uniform grow.

As illustrated on the figure, the noble metal may still form islands, although these islands are all in contact with one another, and the resulting surface may not be perfectly flat.

The noble metal is advantageous when an ionic conductor is used as it acts as blocking electrode for ions diffusion.

Also, it is advantageous as its resistivity can be below 50µOhm.cm and, for a reduced ESR, the thickness of this metallic layer can be comprised between 5 and 20 nanometres.

A capacitor or ionic capacitor is obtained with liner layer 130 and metallic layer 135 forming the top electrode of this capacitor or ionic capacitor.

Figure 2 shows another configuration, in which the bottom electrode of the capacitor or ionic capacitor comprises a liner and a metallic layer.

In particular, above substrate 200 analogous to substrate 100 of figure 1, the device of figure 2 comprises a liner layer 210 analogous to liner layer 130 of figure 1, a metallic layer 215 analogous to metallic layer 135 of figure 1, an intermediate layer 220 analogous to intermediate layer 120 of figure 1, and a top electrode analogous 230 to the bottom electrode 110 of figure 1.

Figure 3 shows another configuration, in which the bottom electrode and the top electrode of the capacitor or ionic capacitor both comprise a liner and a metallic layer.

In particular, above substrate 300 analogous to substrate 100 of figure 1, the device of figure 3 comprises a liner layer 310 analogous to liner layer 210 of figure 2, a metallic layer 315 analogous to metallic layer 215 of figure 2, an intermediate layer 320 analogous to intermediate layer 120 of figure 1, another liner layer 330 analogous to liner layer 130 of figure 1, a metallic layer 335 analogous to metallic layer 135 of figure 1.

Figure 4 shows another example in which a structure such as the one of figure 1 is arranged on a contoured substrate.

Here, the capacitor or ionic capacitor is formed on a substrate comprising:
- a support 400 (for example a glass or semiconductor wafer);
- an anodization barrier layer 405 (tungsten, for example);
- anodic porous material AAO.

This substrate can be obtained using the techniques described in document WO 2015/063420. In particular, here, straight pores are formed in anodic porous oxide that extend from a top surface to reach the anodization barrier layer where the pores are opened.

The capacitive stacked structure or the ionic capacitive stacked structure comprises the following layers, deposited in a conformal manner inside the pores, on the walls of the pores, and at the bottom of the pores:
a bottom electrode layer 410 analogous to layer 110 of figure 1,
an intermediate layer 420 analogous to intermediate layer 120 of figure 1,
a liner layer 430 analogous to liner layer 130 of figure 1, a metallic layer 435 analogous to metallic layer 135 of figure 1.

Further, to form an electrical contact above the top electrode, the pores are filled with a conductive material 440 (for example doped polysilicon).

The devices shown on figures 1 to 4 allow having noble materials for capacitor or ionic capacitor electrodes, with a substantially planar/good uniformity surface because of the presence of a liner that facilitates depositing the noble metal. In fact, this good uniformity is obtained quickly and even for thin films (below 10 nm, while depositing without a liner can lead to a non-uniform/discontinuous metallic layer).

The above described devices are also advantageous as they can be deposited without introducing CI-based contaminants, while maintaining a low resistivity for the electrodes.

Also, using a noble metal is particularly advantageous as it prevents parasitic chemical reactions to occur during the MIM deposition between the electrodes (surface or volume) and the intermediate layer such as oxidation, nitridation etc.).

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A device including an integrated component, comprising:
a substrate (100, 200, 300, 400, 405, AAO),
on the substrate, a stacked structure comprising a bottom electrode, an intermediate layer (120, ..., 420) comprising a layer of dielectric material or a layer of ionic conductor, and a top electrode,
wherein the top and/or the bottom electrode comprises:
a liner layer (130, 210, 310, 330, 430) of material,
a metallic layer (135, 215, 315, 335, 435) on the liner layer, the metallic layer comprising a noble metal, or an intermetallic material, or a refractory metal,
wherein the metallic layer is thicker than the liner layer.

2. The device of claim 1, wherein the metallic layer has a thickness comprised between 5 and 20 nanometres and/or wherein the liner layer is thinner than 1 nanometre.

3. The device of any one of claims 1 or 2, wherein the liner layer is more resistive than the metallic layer, for example the liner layer has a resistivity of less than 50µOhm.cm and the metallic layer has a resistivity of more than 50µOhm.cm.

4. The device of any one of claims 1 to 3, wherein the material of the liner layer is an electron conducting material, for example a metal or a compound-transition-metal or a low bandgap dielectric or a trap rich dielectric allowing direct or indirect electrons tunnelling, for example selected from the list comprising: TiN, TiOx, AlOx, AIN, TaN, TaOx, MoN, WN.

5. The device of any one of claims 1 to 4, wherein the metallic layer comprises a noble metal selected from the list comprising: Pt, Ru, Au, or the metallic layer comprises an intermetallic material selected from the list comprising Ni-Al, Ti-Al, or the metallic layer comprises a refractory metal selected from the list comprising Cr, Mo.

6. The device of any one of claims 1 to 5, wherein the intermediate layer comprises at least one material selected from the list comprising: SiON, HfSiOₓ, SiₓO_{y}, SiₓN_{y}, AlₓO_{y}, HfₓO_{y}, ZrₓO_{y}, TiₓO_{y}, LiₓP_{y}O_{z}Nₓ₁, LiₓSi_{y}P_{z}Oₓ₁N_{y1}, NₓM'_{y}M"_{z}(Pₓ₁O_{y1})_{z}, with M' and M" being metals from the group comprising Al, Ti, Fe and N being an element from the group comprising Li, Na, K.

7. The device of any one of claims 1 to 6, wherein the top electrode comprises the liner layer and the metallic layer, and wherein the bottom capacitor layer comprising a material selected from the list comprising: TiN, Ru, Pt, Au, Cu, W, Mo, AIN, Si, Ti, Al, Co.

8. The device of any one of claims 1 to 7, wherein the stacked structure is a 3D structure wherein the bottom capacitor electrode is contoured, and wherein the intermediate layer, the liner layer and the metallic layer are conformal.

9. The device of claim 8, wherein the substrate comprises an anodic porous oxide region (AAO) comprising a plurality of substantially straight pores that extend from a top surface of the anodic porous oxide region, and wherein the bottom capacitor electrode layer, the intermediate layer, and the top capacitor electrode layer are arranged conformally inside the pores of the anodic porous oxide region.

10. A method of forming an integrated component, comprising:
forming a stacked structure comprising, on a substrate (100, 200, 300, 400, 405, AAO), a bottom electrode, an intermediate layer (120, ..., 420) comprising a layer of dielectric material or a layer of ionic conductor, and a top electrode,
wherein forming the top and/or the bottom electrode comprises forming a liner layer (130, 210, 310, 330, 430) of material, and
forming a metallic layer (135, 215, 315, 335, 435) on the liner layer, the metallic layer comprising a noble metal, or an intermetallic material, or a refractory metal,
wherein the metallic layer is thicker than the liner layer.

11. The method of claim 10, wherein the liner layer is formed by a deposition under a Frank-Van der Merwe growth mode

12. The method of any one of claims 10 or 11, wherein the material of the liner layer is an electron conducting material, for example a metal or a compound-transition-metal or a low bandgap dielectric or a trap rich dielectric allowing direct or indirect electrons tunnelling, for example selected from the list comprising: TiN, TiOx, AIOx, AIN, TaN, TaOx, MoN, WN.

13. The method of claim 12, wherein the liner layer is deposited by ALD using an organometallic precursor, for example comprising TDMAT or TDEAT or TMA or Al-TDMA.

14. The method of any one of claims 10 to 13, wherein the liner layer and the metallic layer are formed by ALD.
